# EUROPÄISCHE PATENTSCHRIFT

(11) **EP 1 404 546 B1**
(45) Veröffentlichungstag und Bekanntmachung des Hinweises auf die Patenterteilung: **16.11.2005**
(21) Anmeldenummer: 02729852.0
(22) Anmeldetag: 05.04.2002
(51) Int. Cl.: B60R 21/01

(54) **VORRICHTUNG ZUM ERFASSEN EINER DEFORMATION EINES BAUELEMENTES**
DEVICE FOR DETECTING THE DEFORMATION OF A STRUCTURAL COMPONENT
DISPOSITIF POUR DETECTER UNE DEFORMATION SUBIE PAR UN COMPOSANT

(30) Priorität: 18.04.2001 DE 10118780
(43) Veröffentlichungstag der Anmeldung: 07.04.2004
(73) Patentinhaber: ROBERT BOSCH GMBH, 70442 Stuttgart (DE)
(72) Erfinder: FUERTSCH, Matthias, 72810 Gomaringen (DE); LORZENZ, Gerd, 72764 Reutlingen (DE)
(86) Internationale Anmeldenummer: PCT/DE2002/001236
(87) Internationale Veröffentlichungsnummer: WO 2002/083462

(56) Entgegenhaltungen:
- DE-A- 19 858 760
- US-A- 4 172 603
- US-A- 4 209 185
- US-A- 5 748 075

## Beschreibung

### STAND DER TECHNIK

Die vorliegende Erfindung betrifft eine Vorrichtung zum Erfassen einer Deformation eines Bauelementes.

Obwohl auf beliebige Bauelemente anwendbar, werden die vorliegende Erfindung sowie die ihr zugrundeliegende Problematik in bezug auf ein Kraftfahrzeugbauelement erläutert.

Zur Detektierung eines Unfalls oder eines Aufpralls eines Kraftfahrzeuges werden allgemein Sensoren in das Kraftfahrzeug eingebaut. Durch Auswertung der Messergebnisse dieser Sensoren können verschiedene sich im Kraftfahrzeug befindliche Insassenschutzanwendungen im Bedarfsfall aktiviert werden. Es werden Drucksensoren in einem an der Seite des Kraftfahrzeuges befindlichen Bauteil, beispielsweise einer Fahrzeugtür, für eine Erfassung eines Seitenaufpralls eingesetzt.

Als nachteilig bei diesem Ansatz hat sich die Tatsache herausgestellt, dass bei Drucksensoren bestimmte Störgrößen eine sichere Erfassung eines Unfalls oder Aufpralls erheblich erschweren. Beispielsweise können Undichtigkeiten im Türaufbau zusätzliche Druckschwankungen verursachen, welche die Messgenauigkeit der Drucksensoren negativ beeinträchtigen.

Ebenfalls kann es beim Unfall zu schweren Beschädigungen des entsprechenden Fahrzeugteils, in das der Drucksensor eingebaut ist, und somit zu ungenauen Messergebnissen oder sogar zu einem Ausfall des Systems kommen.

Auch heftiges Schließen einer Fahrz.eugtür oder Heckklappe kann einen plötzlichen Druckanstieg innerhalb des Kraftfahrzeuges verursachen, wodurch ein fehlerhaftes Signal für eine Auslösung einer Insassenschutzanwendung geliefert wird.

Außerdem erfassen die Drucksensoren lediglich einen begrenzten räumlichen Bereich und sind an die jeweilige räumliche Ausgestaltung des entsprechenden Bauelementes schwer anpassbar.

Aus DE 198 58 760 A1 ist eine Vorrichtung zum Steuern eines Insassenschutzmittel eines Fahrzeugs bekannt. Dabei wird ein Drucksensor in einem Seitenteil eines Fahrzeugs angeordnet und bei einem Aufprall, die durch diesen Aufprall hervorgerufene Druckänderung zu erfassen.

Die der vorliegenden Erfindung zugrundeliegende Problematik besteht also allgemein darin, eine Vorrichtung für eine Erfassung einer Deformation eines Bauelementes zu schaffen, die an das entsprechende Bauelement leicht formanpassbar und von äußeren Störgrößen unabhängig anbringbar ist.

### VORTEILE DER ERFINDUNG

Die der vorliegenden Erfindung zugrundeliegende Idee besteht darin, dass die Vorrichtung eine dem Fahrzeugbauelement als Deformationsindikator zugeordnete deformierbare Hohlkörperanordnung, die mindestens einen Öffnungsbereich aufweist; und mindestens eine Sensoreinrichtung, die zum Messen einer der Deformation der Hohlkörperanordnung entsprechenden Luftströmung im jeweiligen Öffnungsbereich angeordnet ist, aufweist.

Demnach wird die Deformation des Fahrzeugbauelementes über eine Deformation der zugeordneten deformierbaren Hohlkörperanordnung erfasst. Die aufgrund der Deformierung der Hohlkörperanordnung entstehende Luftströmung wird mittels mindestens einer Sensoreinrichtung gemessen.

Die erfindungsgemäße Vorrichtung mit den Merkmalen des Anspruchs 1 und das Verfahren gemäß Anspruch 9 weisen gegenüber dem bekannten Lösungsansatz den Vorteil auf, dass aufgrund der einfachen Bauweise eine billige und dennoch langlebige Vorrichtung geschaffen wird, die gut an bestimmte Bauelemente formanpassbar und vor äußeren Störgrößen geschützt anbringbar ist.

In den Unteransprüchen finden sich vorteilhafte Weiterbildungen und Verbesserungen der in Anspruch 1 angegebenen Vorrichtung und des in Anspruch 9 angegebenen Verfahrens.

Gemäß einer bevorzugten Weiterbildung ist die Hohlkörperanordnung als plastisch oder elastisch verformbarer Behälter, insbesondere als Kunststoffbehälter, ausgebildet. Ein derartiger Behälter ist billig in seiner Herstellung und besitzt eine zufriedenstellende Lebensdauer.

Gemäß einer weiteren bevorzugten Weiterbildung ist die Hohlkörperanordnung mittels mindestens einer Befestigungseinrichtung, beispielsweise einer Befestigungsöse, am Bauelement befestigbar, wobei die mindestens eine Befestigungseinrichtung eine Deformation der Hohlkörperanordnung nicht behindert. Somit kann die Vorrichtung auf einfache Weise an bzw. von Bauteilen verschiedener Formen angebracht bzw. entfernt werden.

Gemäß einer weiteren bevorzugten Weiterbildung ist der Öffnungsbereich der Hohlkörperanordnung vor äußeren Luftströmen geschützt angeordnet. Dies könnte im Kraftfahrzeugbereich derart realisiert sein, dass sich die Vorrichtung und der jeweilige Öffnungsbereich in einer Verkleidung, beispielsweise einer Tür des Kraftfahrzeuges, vorgesehen ist. Somit werden äußere Luftströmungen, beispielsweise beim Zuschlagen einer Tür, von der Sensoreinrichtung ferngehalten und von dieser nicht mit detektiert. Dadurch erhöht sich die Messgenauigkeit der entsprechenden Sensoreinrichtungen.

Gemäß einer weiteren bevorzugten Weiterbildung ist das Bauelement selbst als deformierbare Hohlkörperanordnung ausgebildet. Dabei kann beispielsweise der Innenraum einer Kraftfahrzeugtür die Hohlkörperanordnung bilden und ein Öffnungsbereich zum Fahrzeuginneren hin geschaffen werden.

Dadurch erübrigt sich der Einbau eines zusätzlichen deformierbaren Körpers.

Gemäß einer weiteren bevorzugten Weiterbildung ist die mindestens eine Sensoreinrichtung als Luftmassen- oder Luftgeschwindigkeitssensor ausgebildet. Beide Arten sind prinzipiell dazu geeignet, eine auftretende Luftströmung aufgrund einer Deformation zu detektieren.

Gemäß einer weiteren bevorzugten Weiterbildung sind mehrere Sensoreinrichtungen gleicher oder verschiedener Prinzipien kombinierbar. Die einzelnen Messdaten der Sensoreinrichtungen können in einer Auswerteinheit ausgewertet und mit in einer Speichereinrichtung abgespeicherten Schwellwerten oder Signalmustern verglichen werden. Falls die Messdaten einer oder aller Sensoreinrichtungen bei einer Auswertung Luftströmungswerte im Öffnungsbereich der Hohlkörperanordnung ergeben, die vorbestimmte Schwellwerte übersteigen oder vorgegebenen Signalmustern entsprechen, kann eine Insassenschutzanwendung aktiviert werden. Dadurch erhöht sich mit jeder weiteren Sensoreinrichtung die Zuverlässigkeit eines solchen Systems.

### ZEICHNUNGEN

Ausführungsbeispiele der Erfindung sind in den Zeichnungen dargestellt und in der nachfolgenden Beschreibung näher erläutert.

Es zeigen:
- Fig. 1: eine Vorrichtung zum Erfassen einer Deformation gemäß einem ersten Ausführungsbeispiel der vorliegenden Erfindung;
- Fig. 2: eine Vorrichtung zum Erfassen einer Deformation gemäß einem zweiten Ausführungsbeispiel der vorliegenden Erfindung; und
- Fig. 3: eine schematische Darstellung des Verfahrensablauf zur Aktivierung einer Insassenschutzanwendung bei Erfassung einer Deformation.

### BESCHREIBUNG DER AUSFÜHRUNGSBEISPIELE

In den Figuren bezeichnen gleiche Bezugszeichen gleiche oder funktionsgleiche Komponenten.

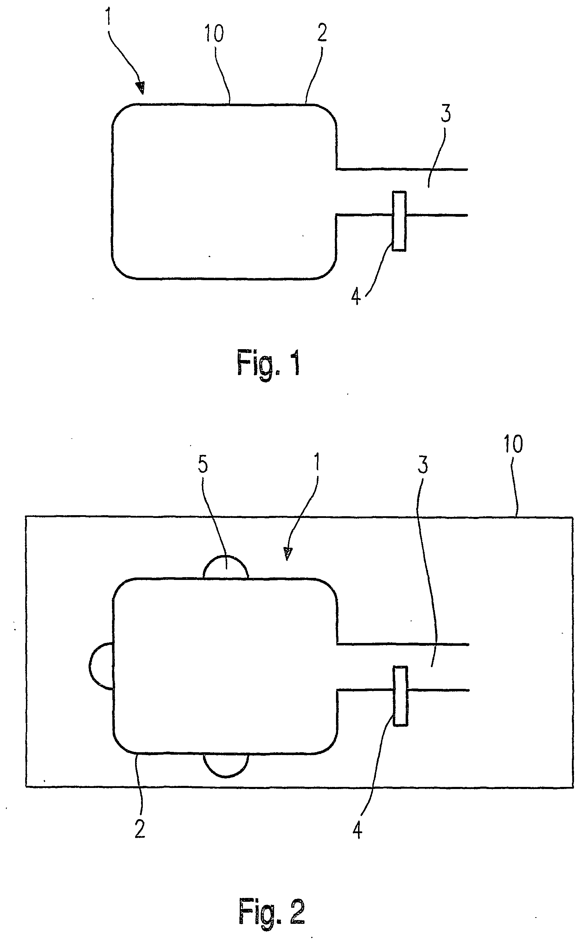

Fig. 1 illustriert eine prinzipielle Darstellung einer Vorrichtung 1 zum Erfassen einer Deformation eines Bauelementes.

Die Vorrichtung 1 besteht dabei aus einer deformierbaren Hohlkörperanordnung 2, die gemäß dem ersten Ausführungsbeispiel selbst ein beliebiges Bauelement 10, beispielsweise eines Kraftfahrzeuges, darstellt. Dabei kann es sich um eine zweischalige Kraftfahrzeugtür oder dergleichen handeln.

Die Hohlkörperanordnung 2 weist gemäß dem ersten Ausführungsbeispiel einen Öffnungsbereich 3 auf, in welchem ein Luftmassen- oder Luftgeschwindigkeitssensor 4 bekannter Ausgestaltung angebracht ist. Der Öffnungsbereich 3 ist vorteilhaft derart angeordnet, dass er vor äußeren Luftströmungen geschützt ist und seine Messdaten nicht von äußeren Störfaktoren beeinflusst werden. Beispielsweise kann in der vorliegenden Ausführungsform der Öffnungsbereich zum Fahrzeuginneren vorgesehen sein.

Über den Sensor 4 ist es möglich, sowohl plötzlich auftretendes Ausströmen der Luft aus dem zusammengepressten Behälter 2 als auch ein Einströmen der Luft in den aufgeblähten Behälter 2 zu detektieren. Anhand der Luftströmungsrichtung kann die Art der Deformierung bzw. des Aufpralls näher spezifiziert werden.

Fig. 2 zeigt eine Vorrichtung 1 zum Erfassen einer Deformation gemäß einem zweiten Ausführungsbeispiel der vorliegenden Erfindung.

Die Hohlkörperanordnung 2 ist demgemäss als elastisch verformbarer Behälter 2, beispielsweise als Kunststoffbehälter 2, ausgebildet und mittels Befestigungsösen 5 an einem Bauelement 10 angebracht. Dabei behindern die Befestigungsösen 5 weder eine Expansion noch eine Kompression des deformierbaren Behälters 2.

Somit erfährt der Behälter bei geeigneter Anbringung an dem Bauelement eine dem Bauelement 10, an dem er mittels den Befestigungsösen 5 angebracht ist, entsprechende Deformation. Über die durch den Öffnungsbereich 3 ein- oder ausströmende Luft können Rückschlüsse auf die Art des Unfalls oder Aufpralls des Kraftfahrzeuges gewonnen werden, der zur Verformung des Bauelementes 10 bzw. des Behälters 2 geführt haben.

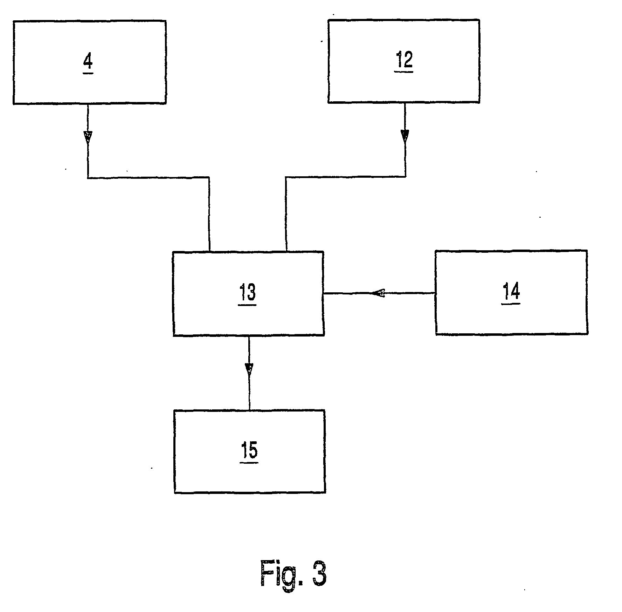

Anhand Fig. 3 wird im folgenden der Verfahrensablauf zum Erfassen einer Deformation eines Bauelements 10 und zum Aktivieren einer entsprechenden Schutzanwendung 15 beschrieben.

Das System gemäß dem in Fig. 3 dargestellten Ausführungsbeispiel weist zwei Sensoreinrichtungen 4, 12 auf. Dabei können die Sensoreinrichtungen 4, 12 auf gleichen oder verschiedenen Sensorprinzipien beruhen, beispielsweise ist die Sensoreinrichtung 4 als Luftmassensensor und die Sensoreinrichtung 12 als Drucksensor ausgebildet.

Die Sensoreinrichtungen 4, 12 detektieren, wie oben bereits erläutert, eine Verformung des Bauelements entweder direkt (siehe erstes Ausführungsbeispiel gemäss Fig.1) oder indirekt (siehe zweites Ausführungsbeispiel gemäss Fig.2).

Die erfassten Messdaten werden an eine Auswerteeinheit 13 übertragen, die mit den Sensoreinrichtungen 4, 12 verbunden ist, und von dieser ausgewertet.

Mit der Auswerteeinheit 13 ist vorteilhaft eine Speichereinrichtung 14 verbunden, in der vorbestimmte Schwellwerte oder Signalmuster abgespeichert sind. Die Auswerteeinheit 13 analysiert die erfassten Messdaten und vergleicht diese mit den in der Speichereinrichtung 14 abgespeicherten Schwellwerte. Falls die Messwerte die vorbestimmten Schwellwerte übersteigen oder nach zeitlichem Verlauf die Höhen der Messdaten einem abgespeicherten Signalmuster ähneln, gleichen oder es übersteigen, wird eine Schutzanwendung 15 mittels eines Signals von der Auswerteeinheit 13 an die entsprechende Schutzanwendung 15 aktiviert.

Die Schwellwerte können einen vorbestimmten Impuls, eine vorbestimmte Luftströmungsgeschwindigkeit, ein vorbestimmter Luftströmungsunterschied, oder dergleichen darstellen.

Die Signalmuster können einen vorbestimmten zeitlichen Signalverlauf, einen vorbestimmten Verlauf der Signalhöhe sowie beliebige mathematische Verknüpfungen von Signalhöhe und zeitlichem Ablauf darstellen.

Die Vorrichtung gemäß der vorliegenden Erfindung weist ferner den Vorteil auf, dass eine Totaldeformation, beispielsweise ein Aufplatzen der Anordnung, aufgrund des Öffnungsbereiches nahezu ausgeschlossen ist. Somit wird die Messvorrichtung bei einem Unfall zusätzlich vor einer Totaldeformation geschützt und kann weitere Messsignale liefern.

Ferner ist die Vorrichtung langlebig, preisgünstig herstellbar und einfach in ein bestehendes System integrierbar.

Obwohl die vorliegende Erfindung anhand eines bevorzugten Ausführungsbeispiels vorstehend beschrieben wurde, ist sie darauf nicht beschränkt, sondern auf vielfältige Weise modifizierbar.

Beispielsweise können mehr als zwei Sensoreinrichtungen für eine weitere Verbesserung der Messgenauigkeit kombiniert und ausgewertet werden. Dabei kann je nach Anwendungsbereich entschieden werden, ob das Bauteil an sich den entsprechenden deformierbaren Hohlkörper darstellt, oder ob eine Hohlkörperanordnung an dem entsprechenden Bauelement zu befestigen ist.

## Patentansprüche

1. Vorrichtung (1) zum Erfassen einer Deformation eines Bauelementes (10), insbesondere im Kraftfahrzeugbereich, mit:
einer dem Bauelement (10) als Deformationsindikator zugeordneten deformierbaren Hohlkörperanordnung (2), die mindestens einen Öffnungsbereich (3) aufweist,
wobei mindestens eine Sensoreinrichtung (4; 12) zum Messen einer der Deformation der Hohlkörperanordnungen (2) entsprechenden Luftströmung im jeweiligen Öffnungsbereich (3) angeordnet ist, **dadurch gekennzeichnet, dass** die mindestens eine Sensoreinrichtung (4) als Luftmassen- oder Luftgeschwindigkeitssensor ausgebildet ist.

2. Vorrichtung nach Anspruch 1, **dadurch gekennzeichnet, dass** die Hohlkörperanordnung (2) als plastisch oder elastisch verformbarer Behälter (2), insbesondere als Kunststoffbehälter, ausgebildet ist.

3. Vorrichtung nach einem der Ansprüche 1 oder 2, **dadurch gekennzeichnet, dass** die Hohlkörperanordnung (2) mittels mindestens einer Befestigungseinrichtung (5), beispielsweise einer Befestigungsöse, am Bauelement (10) befestigbar ist, wobei die mindestens eine Befestigungseinrichtung (5) eine Deformation der Hohlkörperanordnungen (2) zulässt.

4. Vorrichtung nach einem der vorhergehenden Ansprüche, **dadurch gekennzeichnet, dass** der Öffnungsbereich (3) der Hohlkörperanordnung (2) vor äußeren Luftströmungen geschützt anbringbar ist.

5. Vorrichtung nach einem der vorhergehenden Ansprüche, **dadurch gekennzeichnet, dass** die Hohlkörperanordnung (2) in einer Verkleidung, beispielsweise der Tür eines Kraftfahrzeuges, vorgesehen ist.

6. Vorrichtung nach Anspruch 1, **dadurch gekennzeichnet, dass** das Bauelement (10) selbst als deformierbare Hohlkörperanordnung (2) ausgebildet ist.

7. Vorrichtung nach einem der vorhergehenden Ansprüche, **dadurch gekennzeichnet, dass** mehrere Sensoreinrichtungen (4; 12) gleicher oder verschiedener Prinzipien kombinierbar sind.

8. Vorrichtung nach einem der vorhergehenden Ansprüche, **dadurch gekennzeichnet, dass** eine Schutzanwendung (15) aktivierbar ist, falls die Messdaten mindestens einer Sensoreinrichtung (4: 12) bei einer Auswertung Luftströmungswerte im Öffnungsbereich (3) der Hohlkörperanordnung (2) ergeben, die vorbestimmte Schwellwerte übersteigen oder nach zeitlichem Verlauf die Höhen der Messdaten einem vorbestimmten Signalmuster ähneln, gleichen oder es übersteigen.

9. Verfahren zum Erfassen einer Deformation eines Bauelementes (10) und zum Aktivieren einer entsprechenden Schutzanwendung (15), insbesondere im Kraftfahrzeugbereich, mit folgenden Schritten:
Messen einer Deformation einer dem Bauelement (10) als Deformationsindikator zugeordneten Hohlkörperanordnung (2), die mindestens einen Öffnungsbereich (3) aufweist, mittels mindestens einer Sensoreinrichtung (4; 12);
Auswerten der Messdaten der mindestens einen Sensoreinrichtung (4; 12) mittels einer Auswerteeinheit (13); und Aktivieren einer entsprechenden Schutzanwendung (15), falls die Messdaten mindestens einer Sensoreinrichtung (4; 12) eine Deformation der Hohlkörperanordnung (2) und somit des Bauelementes (10) anzeigen, **dadurch gekennzeichnet, dass** die mindestens eine Sensoreinrichtung (4) als Luftmassen oder Luftgeschwindigkeitssensor ausgebildet wird.

10. Verfahren nach Anspruch 9, **dadurch gekennzeichnet, dass** die entsprechende Insassenschutzanmeldung (15) aktiviert wird, falls die Messdaten der Sensoreinrichtung (4) Luftströmungswerte im Öffnungsbereich (3) der Hohlkörperanordnung (2) liefern, die vorbestimmte Schwellwerte übersteigen oder nach zeitlichem Verlauf die Höhen der Messdaten einem vorbestimmten Signalmuster ähneln, gleichen oder es übersteigen.

11. Verfahren einem der Ansprüche 9 oder 10, **dadurch gekennzeichnet, dass** die Hohlkörperanordnung (2) als plastisch oder elastisch verformbarer Behälter (2), insbesondere als Kunststoffbehälter, ausgebildet wird.

12. Verfahren nach einem der Ansprüche 9 bis 11, **dadurch gekennzeichnet, dass** die Hohlkörperanordnung (2) mittels mindestens einer Befestigungseinrichtung (5), beispielsweise einer Befestigungsöse, am Bauelement (10) befestigt wird, wobei die mindestens eine Befestigungseinrichtung (5) eine Deformation der Hohlkörperanordnung (2) zulässt.

13. Verfahren nach einem der Ansprüche 9 bis 12, **dadurch gekennzeichnet, dass** der Öffnungsbereich (3) der Hohlkörperanordnung (2) vor äußeren Luftströmungen geschützt angeordnet wird.

14. Verfahren nach einem der Ansprüche 9 bis 13, **dadurch gekennzeichnet, dass** die Hohlkörperanordnung (2) in einer Verkleidung, beispielsweise in einer Tür eines Kraftfahrzeuges, vorgesehen wird.

15. Verfahren nach Anspruch 9, **dadurch gekennzeichnet, dass** das Bauelement (10) selbst als deformierbare Hohlkörperanordnung (2) ausgebildet wird.

16. Verfahren nach einem der Ansprüche 9 bis 15, **dadurch gekennzeichnet, dass** mehrere Sensoreinrichtungen (4; 12) gleicher oder verschiedener Prinzipien kombiniert werden.

## Claims

1. Device (1) for detecting a deformation of a structural element (10), in particular in the motor vehicle sector, with:
a deformable hollow body arrangement (2) which is assigned as a deformation indicator to the structural element (10) which has at least one orifice region (3),
at least one sensor means (4; 12) for measuring an airflow which corresponds to the deformation of the hollow body arrangements (2) being arranged in the respective orifice region (3), **characterized in that** the at least one sensor means (4) is designed as an air-mass or air-velocity sensor.

2. Device according to Claim 1, **characterized in that** the hollow body arrangement (2) is designed as a plastically or elastically deformable container (2), in particular as a plastic container.

3. Device according to either one of Claims 1 and 2, **characterized in that** the hollow body arrangement (2) can be fastened to the structural element (10) by at least one fastening means (5), for example a fastening lug, the at least one fastening means (5) allowing a deformation of the hollow body arrangements (2).

4. Device according to one of the preceding claims, **characterized in that** the orifice region (3) of the hollow body arrangement (2) can be mounted so as to be protected from external airflows.

5. Device according to one of the preceding claims, **characterized in that** the hollow body arrangement (2) is provided in a panelling, for example the door of a motor vehicle.

6. Device according to Claim 1, **characterized in that** the structural element (10) itself is designed as a deformable hollow body arrangement (2).

7. Device according to one of the preceding claims, **characterized in that** a plurality of sensor means (4, 12) of identical or different principles can be combined.

8. Device according to one of the preceding claims, **characterized in that** a protective application (15) can be activated if, during an evaluation, the measurement data from at least one sensor means (4; 12) yield, in the orifice region (3) of the hollow body arrangement (2), airflow values which overshoot predetermined threshold values, or, according to a time profile, the magnitudes of the measurement data are similar to, are equal to or overshoot a predetermined signal pattern.

9. Method for detecting a deformation of a structural element (10) and for activating a corresponding protective application (15), in particular in the motor vehicle sector, with the following steps:
measurement of a deformation of a hollow body arrangement (2) which is assigned as a deformation indicator for the structural element (10) and which has at least one orifice region (3) by at least one sensor means (4; 12);
evaluation of the measurement data from the at least one sensor means (4; 12) by means of an evaluation unit (13); and
activation of a corresponding protective application (15) if the measurement data from at least one sensor means (4; 12) indicate a deformation of the hollow body arrangement (2) and therefore of the structural element (10), **characterized in that** the at least one sensor means (4) is designed as an air-mass or air-velocity sensor.

10. Method as claimed in Claim 9, **characterized in that** the corresponding occupant protection application (15) is activated if the measurement data from the sensor means (4) deliver, in the orifice region (3) of the hollow body arrangement (2), airflow values which overshoot predetermined threshold values, or, according to a time profile, the magnitudes of the measurement data are similar to, are equal to or overshoot a predetermined signal pattern.

11. Method according to either one of Claims 9 and 10, **characterized in that** the hollow body arrangement (2) is designed as a plastically or elastically deformable container (2), in particular as a plastic container.

12. Method according to one of Claims 9 to 11, **characterized in that** the hollow body arrangement (2) is fastened to the structural element (10) by at least one fastening means (5), for example a fastening lug, the at least one fastening means (5) allowing a deformation of the hollow body arrangement (2).

13. Method according to one of Claims 9 to 12, **characterized in that** the orifice region (3) of the hollow body arrangement (2) is arranged so as to be protected from external airflows.

14. Method according to one of Claims 9 to 13, **characterized in that** the hollow body arrangement (2) is provided in a panelling, for example in a door of a motor vehicle.

15. Method according to Claim 9, **characterized in that** the structural element (10) itself is designed as a deformable hollow body arrangement (2).

16. Method according to one of Claims 9 to 15, **characterized in that** a plurality of sensor means (4; 12) of identical or different principles are combined.

## Revendications

1. Dispositif (2) pour détecter une déformation d'un composant (10), notamment dans le secteur automobile, avec :
un corps creux (2) déformable associé au composant (10) en tant qu'indicateur de déformation et présentant au moins une zone d'ouverture (3), et au moins un dispositif capteur (4 ; 12) disposé dans la zone d'ouverture (3) respective pour mesurer un courant d'air correspondant à la déformation des corps creux (2),
**caractérisé en ce que**
l'au moins un dispositif capteur (4) est un capteur de masse d'air ou de vitesse d'air.

2. Dispositif selon la revendication 1,
**caractérisé en ce que**
le corps creux (2) est un récipient (2) déformable plastiquement ou élastiquement, notamment un récipient en matière plastique.

3. Dispositif selon l'une quelconque des revendications 1 ou 2,
**caractérisé en ce que**
le corps creux (2) peut être fixé au composant (10) par au moins un dispositif de fixation (5), par exemple un oeillet de fixation, ce dispositif de fixation (5) permettant une déformation du corps creux (2).

4. Dispositif selon l'une quelconque des revendications précédentes,
**caractérisé en ce que**
la zone d'ouverture (3) du corps creux (2) peut être installée de manière à être protégée contre des courants d'air extérieurs.

5. Dispositif selon l'une quelconque des revendications précédentes,
**caractérisé en ce que**
le corps creux (2) est prévu dans un habillage, par exemple de la porte d'un véhicule automobile.

6. Dispositif selon la revendication 1,
**caractérisé en ce que**
le composant (10) est lui-même un corps creux (2) déformable.

7. Dispositif selon l'une quelconque des revendications précédentes,
**caractérisé en ce qu'**
on peut combiner plusieurs dispositifs capteurs (4 ; 12) de principes identiques ou différents.

8. Dispositif selon l'une quelconque des revendications précédentes,
**caractérisé en ce qu'**une application de protection (15) peut être activée si les données de mesure d'au moins un dispositif capteur (4 ; 12) lors d'une exploitation indiquent des valeurs de courant d'air dans la zone d'ouverture (3) du corps creux (2) qui dépassent des valeurs seuils prédéterminées, ou si après un écoulement de temps les montants des données de mesure sont similaires, égaux ou supérieurs à un modèle de signal prédéterminé.

9. Procédé pour détecter une déformation d'un composant (10) et activer une application de protection (15) correspondante, notamment dans le secteur automobile, comprenant les étapes suivantes : mesure d'une déformation d'un corps creux (2) déformable associé au composant (10) en tant qu'indicateur de déformation et présentant au moins une zone d'ouverture (3), au moyen d'au moins un dispositif capteur (4 ; 12) ; exploitation des données de mesure d'au moins un dispositif capteur (4 ; 12) au moyen d'une unité d'exploitation ; et activation d'une application de protection (15) correspondante si les données de mesure d'au moins un dispositif capteur (4 ; 12) indiquent une déformation du corps creux (2) et donc du composant (10),
**caractérisé en ce qu'**
au moins un dispositif capteur (4) est un capteur de masse d'air ou de vitesse d'air.

10. Procédé selon la revendication 9,
**caractérisé en ce que**
l'application de protection de passager (15) correspondant est activée si les données de mesure du dispositif capteur (4) indiquent des valeurs de débit d'air dans la zone d'ouverture (3) du corps creux (2) qui dépassent des valeurs seuils prédéterminées, ou si après un écoulement de temps les montants des données de mesure sont similaires, égaux ou supérieurs à un modèle de signal prédéterminé.

11. Procédé selon l'une quelconque des revendications 9 ou 10,
**caractérisé en ce que**
le corps creux (2) est un récipient (2) déformable plastiquement ou élastiquement, notamment un récipient en matière plastique.

12. Procédé selon l'une quelconque des revendications 9 à 11,
**caractérisé en ce que**
le corps creux (2) est fixé au composant (10) par au moins un dispositif de fixation (5), par exemple un oeillet de fixation, ce dispositif de fixation (5) permettant une déformation du corps creux (2).

13. Procédé selon l'une quelconque des revendications 9 à 12,
**caractérisé en ce que**
la zone d'ouverture (3) du corps creux (2) est installée de manière à être protégée contre des courants d'air extérieurs.

14. Procédé selon l'une quelconque des revendications 9 à 13,
**caractérisé en ce que**
le corps creux (2) est prévu dans un habillage, par exemple de la porte d'un véhicule automobile.

15. Procédé selon la revendication 9,
**caractérisé en ce que**
le composant (10) est lui-même un corps creux (2) déformable.

16. Procédé selon l'une quelconque des revendications 9 à 15,
**caractérisé en ce que**
plusieurs dispositifs capteurs (4 ; 12) de principes identiques ou différents sont combinés.
